# EUROPEAN PATENT SPECIFICATION

(11) **EP 3 753 910 B1**
(45) Date of publication and mention of the grant of the patent: **29.04.2026**
(21) Application number: 19753913.3
(22) Date of filing: 08.02.2019
(51) Int. Cl.: C03C 27/12, C08K 5/14, C08L 23/08, C08L 31/02, B32B 17/10, C08J 5/18

(54) **RESIN COMPOSITION FOR LAMINATED GLASS INTERLAYER FILM OR SOLAR CELL SEALING MATERIAL, LAMINATED GLASS INTERLAYER FILM, LAMINATED GLASS, SOLAR CELL SEALING MATERIAL, AND SOLAR CELL MODULE**
HARZZUSAMMENSETZUNG FÜR VERBUNDGLASZWISCHENSCHICHTFILM ODER SOLARZELLENVERSIEGELUNGSMATERIAL, VERBUNDGLASZWISCHENSCHICHTFILM, VERBUNDGLAS, SOLARZELLENVERSIEGELUNGSMATERIAL UND SOLARZELLENMODUL
COMPOSITION DE RÉSINE POUR FILM DE COUCHE INTERMÉDIAIRE DE VERRE FEUILLETÉ OU MATÉRIAU D'ENCAPSULATION DE CELLULE SOLAIRE, FILM DE COUCHE INTERMÉDIAIRE DE VERRE FEUILLETÉ, VERRE FEUILLETÉ, MATÉRIAU D'ENCAPSULATION DE CELLULE SOLAIRE, ET MODULE DE CELLULE SOLAIRE

(30) Priority: 14.02.2018 JP 2018024177
(43) Date of publication of application: 23.12.2020
(73) Proprietor: Dow-Mitsui Polychemicals Co., Ltd., Tokyo 104-0028 (JP)
(72) Inventor: FUKUYAMA Kana, Ichihara-shi, Chiba 299-0108 (JP); SATO Norihiko, Ichihara-shi, Chiba 299-0108 (JP); KOMATSU Harunobu, Sodegaura-shi, Chiba 299-0265 (JP); NAGAYAMA Kei, Ichihara-shi, Chiba 299-0108 (JP); ISOKAWA Motoaki, Ichihara-shi, Chiba 299-0108 (JP)
(74) Representative: Gulde & Partner
(86) International application number: PCT/JP2019/004704
(87) International publication number: WO 2019/159852

(56) References cited:
- EP-B1- 3 630 905
- WO-A1-2016/194606
- WO-A1-2017/150217
- JP-A- 2012 052 004
- JP-A- 2012 067 174
- JP-A- 2018 162 175

## Description

### TECHNICAL FIELD

The present invention relates to a resin composition for a laminated glass interlayer film or a solar cell encapsulant, a laminated glass interlayer film, a laminated glass, a solar cell encapsulant, and a solar cell module.

### BACKGROUND ART

As a laminated glass interlayer film or a solar cell encapsulant, a film formed from an ethylene-unsaturated ester copolymer and a crosslinking agent is known.

Examples of techniques relating to such a laminated glass interlayer film include those described in Patent Document 1 (Pamphlet of International Publication No. WO2014/208756) and Patent Document 2 (Japanese Unexamined Patent Publication No. 2007-331952) .

Patent Document 1 discloses a sheet for forming a laminate used in a method for producing a laminate including a step of applying pressure by using a nip roll, wherein the sheet for forming a laminate is formed of a composition containing an ethylene-vinyl acetate copolymer and a crosslinking agent, the content of vinyl acetate in the ethylene-vinyl acetate copolymer is 30% by mass or more based on the ethylene-vinyl acetate copolymer, and the ethylene-vinyl acetate copolymer has a melt flow rate (according to JIS-K7210) of 5 g/10 min or less.

Patent Document 2 discloses an interlayer film for a laminated glass, which contains an ethylene/vinyl acetate copolymer and an organic peroxide, wherein the organic peroxide is a peroxyketal represented by a specific chemical formula and having a 10-hour half-life at a temperature of 100°C or less.

Patent Document 3 discloses a resin composition for a solar cell encapsulant, comprising 100 parts of ethylene-vinyl acetate copolymer (EVA) having a vinyl acetate content of 33%, 0.75 parts of t-butylperoxy-2-ethylhexyl carbonate as crosslinking agent (TBEC), and 0.5 parts of triallyl isocyanurate as cross-linking aid (TAIC).

### RELATED DOCUMENT

### PATENT DOCUMENT

[Patent Document 1] WO 2014/208756 A1
[Patent Document 2] JP 2007-331952 A
[Patent Document 3] JP 2012-52004 A

### SUMMARY OF THE INVENTION

### TECHNICAL PROBLEM

The technical level required from a laminated glass interlayer film in connection with various characteristics is ever increasing. The inventors of the present invention found the following problems in relation to laminated glass interlayer films.

First, the laminated glass interlayer films formed from an ethylene-unsaturated ester copolymer and a crosslinking agent as disclosed in Patent Documents 1 and 2 do not have sufficiently satisfactory optical characteristics and adhesiveness under high humidity conditions (hereinafter, also referred to as moisture-resistant adhesiveness).

That is, the present inventors have found that there is room for improvement in conventional laminated glass interlayer film formed from an ethylene-unsaturated ester copolymer and a crosslinking agent, from the viewpoint of enhancing the optical characteristics and moisture-resistant adhesiveness in a well-balanced manner.

Furthermore, a solar cell encapsulant also has problems similar to the case of the laminated glass interlayer film.

The present invention was achieved in view of the above-described circumstances, and it is an object of the invention to provide a resin composition for a laminated glass interlayer film or a solar cell encapsulant, the interlayer film and the encapsulant having an excellent performance balance between optical characteristics and moisture-resistant adhesiveness.

### SOLUTION TO PROBLEM

The inventors of the present invention conducted a thorough investigation in order to achieve the object described above. As a result, it has become clear that the resin composition having a high crosslinking rate tends to be inferior in the moisture-resistant adhesiveness and the bubble escape during the production of laminated glass. On the other hand, it has been found that by reducing the crosslinking rate of the resin composition, the moisture-resistant adhesiveness is improved while maintaining good optical characteristics of the crosslinked film thus obtainable.

The present inventors further conducted an investigation based on the above findings, and have found that when the torque of a resin composition is measured over time at 130°C using a moving die rheometer, the torque value 60 minutes after the start of measurement is defined as T₁₀₀ [dN·m], the torque value of 10% of T₁₀₀ is defined as T₁₀, the torque value of 50% of T₁₀₀ is defined as T₅₀, the minimum torque value during measurement is defined as Tₘᵢₙ, the time to reach T₁₀ from the start of measurement is defined as X [min], and the time to reach T₅₀ from the start of measurement is defined as Y [min], the value represented by (T₅₀-T₁₀)/(Y-X) (where T₅₀ = (T₁₀₀-Tₘᵢₙ) × 0.5 + Tₘᵢₙ, T₁₀ = (T₁₀₀-Tₘᵢₙ) × 0.1 + Tₘᵢₙ) can be used as an index for evaluating the crosslinking rate of the resin composition.

As a result of the thorough investigation based on these findings, it has been found that adjusting the crosslinking rate represented by (T₅₀-T₁₀) / (Y-X) to a specific range and adjusting the melt flow rate of the ethylene-unsaturated ester copolymer to a specific range can effectively improve the performance balance between optical characteristics and moisture-resistant adhesiveness of the laminated glass interlayer film or the solar cell encapsulant, leading to the completion of the present invention.

That is, according to the present invention, a resin composition for a laminated glass interlayer film or a solar cell encapsulant, a laminated glass interlayer film, a laminated glass, a solar cell encapsulant, and a solar cell module as disclosed below are provided.

[1] A resin composition for a laminated glass interlayer film or a solar cell encapsulant,
   the resin composition containing an ethylene-unsaturated ester copolymer (A) and a crosslinking agent (B),
   wherein
   when a total amount of the ethylene-unsaturated ester copolymer (A) is designated as 100% by mass, a content of constituent units derived from an unsaturated ester in the ethylene-unsaturated ester copolymer (A) is 30% by mass or more and 48% by mass or less; and
   when a torque of the resin composition is measured over time at 130°C using a moving die rheometer, a torque value 60 minutes after the start of measurement is defined as T₁₀₀ [dN·m], a torque value of 10% of T₁₀₀ is defined as T₁₀, a torque value of 50% of T₁₀₀ is defined as T₅₀, a minimum torque value during measurement is defined as Tₘᵢₙ, a time to reach T₁₀ from the start of measurement is defined as X [min], and a time to reach T₅₀ from the start of measurement is defined as Y [min],
   a crosslinking rate represented by (T₅₀-T₁₀) / (Y-X) (where T₅₀ = (T₁₀₀-Tₘᵢₙ) × 0. 5 + Tₘᵢₙ, T₁₀ = (T₁₀₀-Tₘᵢₙ) × 0.1 + Tₘᵢₙ) is more than 0.01 dN·m/min and 0.25 dN·m/min or less,
   wherein the ethylene-unsaturated ester copolymer (A) has a melt flow rate (MFR) of 10 g/10 minutes or less as measured according to JIS K7210: 1999 under the conditions of 190°C and 2,160 g load.
[2] The resin composition according to [1],
   wherein the ethylene-unsaturated ester copolymer (A) contains at least one polymer selected from an ethylene-vinyl ester copolymer and an ethylene-unsaturated carboxylic acid ester copolymer.
[3] The resin composition according to [2],
   wherein the ethylene-unsaturated ester copolymer (A) contains an ethylene-vinyl acetate copolymer.
[4] The resin composition according to any of [1] to [3],
   wherein when a total amount of the ethylene-unsaturated ester copolymer (A) is designated as 100% by mass, a content of constituent units derived from an unsaturated ester in the ethylene-unsaturated ester copolymer (A) is 30% by mass or more and 46% by mass or less.
[5] The resin composition according to any of [1] to [4],
   wherein the crosslinking agent (B) contains an organic peroxide.
[6] The resin composition according to any of [1] to [5],
   wherein a haze as measured by the following method is less than 2.5%:
   (Method)
   A film having a size of 120 mm × 75 mm and formed from the composition is obtained. Next, the film thus obtained is interposed between glass plates each having a size of 120 mm × 75 mm × 3.2 mm, and is subjected to thermal crimping for 60 minutes at 130°C and 1 atm in a vacuum laminator to obtain a laminated glass. Next, the haze of the laminated glass thus obtained is measured according to JIS K7136: 2000 using a haze meter.
[7] The resin composition according to any of [1] to [6],
   wherein a protrusion length as measured by the following method is less than 10 mm:
   (Method)
   A film having a size of 120 mm × 75 mm and formed from the composition is obtained. Next, the film thus obtained is interposed between glass plates each having a size of 120 mm × 75 mm × 3.2 mm, and is subjected to thermal crimping for 60 minutes at 130°C and 1 atm in a vacuum laminator to obtain a laminated glass. Next, a protrusion length of the resin composition thus obtained protruding from an edge of the laminated glass in a direction perpendicular to a cross-section of the laminated glass is measured.
[8] The resin composition according to any of [1] to [7],
   wherein the resin composition is in the form of a sheet or a film.
[9] A laminated glass interlayer film formed from the resin composition according to any of [1] to [8].
[10] A laminated glass including:
   the laminated glass interlayer film according to [9]; and a transparent plate-like member provided on both surfaces of the laminated glass interlayer film.
[11] A solar cell encapsulant formed from the resin composition according to any of [1] to [8].
[12] A solar cell module containing the solar cell encapsulant according to [11].

### ADVANTAGEOUS EFFECTS OF INVENTION

According to the present invention, it is possible to provide a resin composition for a laminated glass interlayer film or a solar cell encapsulant having an excellent performance balance between optical characteristics and moisture-resistant adhesiveness.

### BRIEF DESCRIPTION OF THE DRAWINGS

The object described above, and other objects, features, and advantages will be further clarified by suitable embodiments that will be described below and the following drawings attached thereto.

Fig. 1 is a graph schematically showing a relationship between a torque value obtained by measurement using a moving die rheometer (MDR, Moving Die Rheometer) and measurement time.
Fig. 2 is a cross-sectional view schematically illustrating an example of a structure of a laminated glass according to an embodiment of the present invention.

### DESCRIPTION OF EMBODIMENTS

Hereinafter, the embodiments of the present invention will be explained using a drawing. The diagram is an outline diagram and is not consistent with the actual dimensional ratios. Meanwhile, unless particularly stated otherwise, the expression "X to Y" of a numerical value range represents a range of equal to or more than X and equal to or less than Y. Furthermore, the term (meth)acryl means acryl or methacryl.

### 1. Resin composition

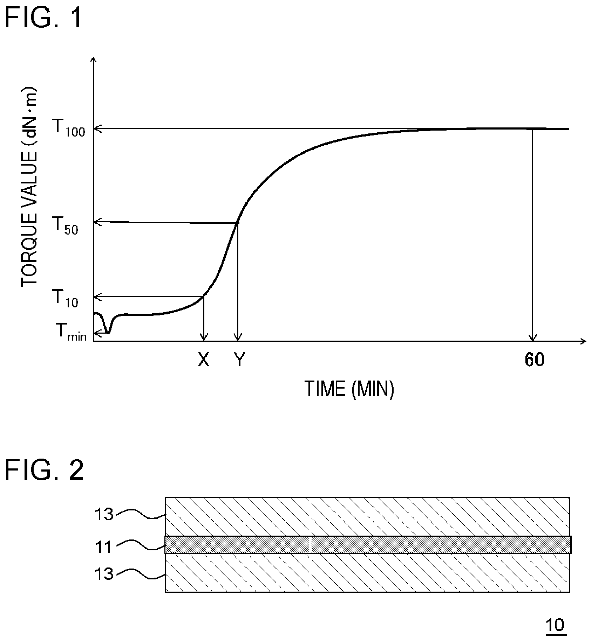

Fig. 1 is a graph schematically showing a relationship between a torque value obtained by measurement using a moving die rheometer and measurement time. Fig. 2 is a cross-sectional view schematically illustrating an example of the structure of a laminated glass 10 according to the embodiments of the present invention.

A resin composition (P) according to the present embodiment is a resin composition used for forming a laminated glass interlayer film 11 or a solar cell encapsulant, which contains an ethylene-unsaturated ester copolymer (A) and a crosslinking agent (B), wherein when the torque of the resin composition is measured over time at 130°C using a moving die rheometer, the torque value 60 minutes after the start of measurement is defined as T₁₀₀ [dN·m], the torque value of 10% of T₁₀₀ is defined as T₁₀, the torque value of 50% of T₁₀₀ is defined as T₅₀, the minimum torque value during measurement is defined as Tₘᵢₙ, the time to reach T₁₀ from the start of measurement is defined as X [min], and the time to reach T₅₀ from the start of measurement is defined as Y [min], the crosslinking rate represented by (T₅₀-T₁₀) / (Y-X) (where T₅₀ = (T₁₀₀-Tₘᵢₙ) × 0.5 + Tₘᵢₙ, T₁₀ = (T₁₀₀-Tₘᵢₙ) × 0.1 + Tₘᵢₙ) is more than 0.01 dN·m/min and 0.25 dN·m/min or less.

Here, the measurement of the torque values (T₁₀, T₅₀, T₁₀₀) of the resin composition (P) according to the present embodiment using a moving die rheometer may be performed according to the following conditions.

The torque values (T₁₀, T₅₀, T₁₀₀) of the resin composition (P) of the present embodiment may be measured by measuring the melting torque of the resin composition (P) over time under the condition of the measurement temperature of 130°C and the frequency of 1.66 Hz using a moving die rheometer (product name: MDR-2000P) manufactured by Alpha Technology Co., Ltd. as the measuring apparatus.

According to the investigation of the present inventors, it has become clear that the laminated glass interlayer films formed from an ethylene-unsaturated ester copolymer and a crosslinking agent as disclosed in Patent Documents 1 and 2 do not have sufficiently satisfactory optical characteristics and adhesiveness under high humidity conditions.

That is, the present inventors have found that there is room for improvement in conventional laminated glass interlayer film formed from an ethylene-unsaturated ester copolymer and a crosslinking agent, from the viewpoint of enhancing the optical characteristics and moisture-resistant adhesiveness in a well-balanced manner.

Furthermore, a solar cell encapsulant also has problems similar to the case of the laminated glass interlayer film.

The inventors of the present invention conducted a thorough investigation in order to achieve the object described above. As a result, it has become clear that the resin composition having a high crosslinking rate tends to be inferior in moisture-resistant adhesiveness. On the other hand, it has been found that by reducing the crosslinking rate of the resin composition, the moisture-resistant adhesiveness is improved while maintaining good optical characteristics of the crosslinked film thus obtainable.

The present inventors further conducted an investigation based on the above findings, and have found that when the torque of a resin composition is measured over time at 130°C using a moving die rheometer, the torque value 60 minutes after the start of measurement is defined as T₁₀₀ [dN·m], the torque value of 10% of T₁₀₀ is defined as T₁₀, the torque value of 50% of T₁₀₀ is defined as T₅₀, the minimum torque value during measurement is defined as Tₘᵢₙ, the time to reach T₁₀ from the start of measurement is defined as X [min], and the time to reach T₅₀ from the start of measurement is defined as Y [min], the value represented by (T₅₀-T₁₀)/ (Y-X) (where T₅₀ = (T₁₀₀-Tₘᵢₙ) × 0.5 + Tₘᵢₙ, T₁₀ = (T₁₀₀-Tₘᵢₙ) × 0.1 + Tₘᵢₙ) can be used as an index for evaluating the crosslinking rate of the resin composition.

As a result of the thorough investigation based on these findings, it has been found that adjusting the crosslinking rate represented by (T₅₀-T₁₀)/(Y-X) to a specific range can effectively improve the performance balance between optical characteristics and moisture-resistant adhesiveness of the laminated glass interlayer film or the solar cell encapsulant, leading to the completion of the present invention.

That is, the resin composition (P) according to the present embodiment is configured such that the crosslinking rate represented by (T₅₀-T₁₀)/(Y-X) is in the range of more than 0.01 dN·m/min and 0.25 dN·m/min or less, whereby the performance balance between optical characteristics and moisture-resistant adhesiveness of the laminated glass interlayer film or the solar cell encapsulant can be improved.

Although the reason why the performance balance between the optical characteristics and the moisture-resistant adhesiveness of the laminated glass interlayer film or the solar cell encapsulant can be improved by setting the crosslinking rate represented by (T₅₀-T₁₀)/(Y-X) within the above range is unclear, it is considered that by adjusting the crosslinking rate of the resin composition within the above range, the crosslinking of the resin composition proceeds more gently and at an appropriate rate, and when the crosslinking reaction of the resin composition is in progress, moisture, bubbles, and the like, contained in the resin composition are easily degassed, and as a result, the amount of bubbles, and the like, in the resulting crosslinked film can be suppressed, and the optical characteristics and moisture-resistant adhesiveness can be improved.

In the present embodiment, the optical characteristics mean, for example, haze, total light transmittance and the like.

In the present embodiment, the crosslinking rate represented by (T₅₀-T₁₀) / (Y-X) is more than 0.01 dN·m/min, but is preferably 0.02 dN·m/min or more, and more preferably 0.03 dN·m/min or more, from the viewpoint of further improving the mechanical characteristics and heat resistance of the laminated glass interlayer film or solar cell encapsulant thus obtainable, and further suppressing the resin protrusion from the edge of the laminated glass and solar cell modules.

Further, in the present embodiment, the crosslinking rate represented by (T₅₀-T₁₀) / (Y-X) is 0.25 dN·m/min or less, and is preferably 0.20 dN·m/min or less, more preferably 0.17 dN·m/min or less, and particularly preferably 0.15 dN·m/min or less, from the viewpoint of further improving the performance balance between optical characteristics and moisture-resistant adhesiveness of the laminated glass interlayer film or solar cell encapsulant thus obtainable.

In the present embodiment, when the torque of the resin composition (P) is measured over time, the lower limit of the torque value T₁₀₀ after 60 minutes from the start of measurement is, for example, 1.5 dN·m or more, and preferably 1.8 dN·m or more. This makes it possible to further improve the shape stability, crosslinkability, heat resistance, mechanical characteristics, handleability, workability, and the like of the laminated glass interlayer film or solar cell encapsulant thus obtainable. Further, the upper limit of the torque value T₁₀₀ is, for example, 12.0 dN·m or less, preferably 8.0 dN·m or less, and more preferably 6.0 dN·m or less. This makes it possible to further improve the performance balance between optical characteristics and moisture-resistant adhesiveness of the laminated glass interlayer film or solar cell encapsulant thus obtainable.

In the present embodiment, for example, by appropriately selecting the type of the ethylene-unsaturated ester copolymer (A), the 1-hour half-life temperature of the crosslinking agent (B), the content of the crosslinking agent (B), and the like, the crosslinking rate represented by (T₅₀-T₁₀) / (Y-X) and the torque value T₁₀₀ of the resin composition (P) according to the present embodiment can be controlled within a desired range.

Among these, for example, the MFR of the ethylene-unsaturated ester copolymer (A), which will be described later, the 1-hour half-life temperature of the crosslinking agent (B), the content of the crosslinking agent (B), and the like can be included as factors for setting the crosslinking rate represented by (T₅₀-T₁₀) / (Y-X) and the torque value T₁₀₀ of the resin composition (P) according to the present embodiment within a desired numerical value range. For example, when the MFR of the ethylene-unsaturated ester copolymer (A) is lowered, the 1-hour half-life temperature of the crosslinking agent (B) is increased, or the content of the crosslinking agent (B) is decreased, the crosslinking rate can be reduced.

Hereinafter, various components constituting the resin composition (P) according to the present embodiment will be described.

### <Ethylene-unsaturated ester copolymer (A)>

The ethylene-unsaturated ester copolymer (A) according to the present embodiment is a polymer obtained by copolymerizing ethylene and at least one unsaturated ester. Examples of the ethylene-unsaturated ester copolymer (A) include copolymers containing ethylene and unsaturated esters.

Further, the ethylene-unsaturated ester copolymer (A) preferably contains at least one polymer selected from an ethylene-vinyl ester copolymer and an ethylene-unsaturated carboxylic acid ester copolymer.

Further, the ethylene-unsaturated ester copolymer (A) according to the present embodiment may contain a polymerizable monomer other than ethylene and unsaturated esters, and examples thereof include olefins such as propylene, butene, and hexene.

As the ethylene-vinyl ester copolymer according to the present embodiment, one or more selected from ethylene-vinyl acetate copolymer, ethylene-vinyl propionate copolymer, ethylene-vinyl butyrate copolymer, ethylene-vinyl stearate copolymer may be used.

The ethylene-unsaturated carboxylic acid ester copolymer (A) according to the present embodiment is a polymer obtained by copolymerizing ethylene and at least one unsaturated carboxylic acid ester.

Specific examples thereof include copolymers containing ethylene and an unsaturated carboxylic acid alkyl ester.

Examples of the unsaturated carboxylic acid in the unsaturated carboxylic acid ester include acrylic acid, methacrylic acid, 2-ethylacrylic acid, crotonic acid, maleic acid, fumaric acid, itaconic acid, maleic anhydride, fumaric anhydride, itaconic anhydride, monomethyl maleate, and monoethyl maleate.

Among these, from the viewpoints of productivity, hygiene, and the like of the ethylene-unsaturated ester copolymer (A), the unsaturated carboxylic acid preferably includes at least one selected from acrylic acid and methacrylic acid. These unsaturated carboxylic acids may be used singly, or two or more kinds thereof may be used in combination.

Examples of the alkyl moiety in the unsaturated carboxylic acid alkyl ester include those having 1 to 12 carbon atoms, and more specific examples thereof include alkyl groups such as methyl, ethyl, n-propyl, isopropyl, n-butyl, isobutyl, secondary butyl, 2-ethylhexyl and isooctyl. In the present embodiment, the alkyl moiety of the alkyl ester preferably has 1 to 8 carbon atoms.

The unsaturated carboxylic acid ester preferably contains one or more selected from (meth)acrylic acid esters such as methyl (meth)acrylate, ethyl (meth)acrylate, isopropyl (meth)acrylate, n-propyl (meth)acrylate, isobutyl (meth)acrylate, n-butyl (meth)acrylate, isooctyl (meth)acrylate, and 2-ethylhexyl (meth)acrylate. These unsaturated carboxylic acid esters may be used singly, or two or more kinds thereof may be used in combination. Among these, one or more selected from methyl (meth)acrylate, ethyl (meth)acrylate, isopropyl (meth)acrylate, n-propyl (meth)acrylate, isobutyl (meth)acrylate, and n-butyl (meth)acrylate are more preferred.

In the present embodiment, a preferred ethylene-unsaturated carboxylic acid ester copolymer is an ethylene-(meth)acrylic acid ester copolymer. Among them, a copolymer composed of one kind of compound is preferable as the (meth)acrylic acid ester. Examples of such copolymers include ethylene-methyl (meth) acrylate copolymer, ethylene-ethyl (meth)acrylate copolymer, ethylene-isopropyl (meth)acrylate copolymer, ethylene-n-propyl (meth)acrylate copolymer, ethylene-isobutyl (meth)acrylate copolymer, ethylene-n-butyl (meth)acrylate copolymer, ethylene-isooctyl (meth) acrylate copolymer, and ethylene-2-ethylhexyl (meth)acrylate copolymer.

The ethylene-unsaturated ester copolymer (A) preferably contains one or more selected from an ethylene-vinyl acetate copolymer, ethylene-methyl (meth)acrylate copolymer, ethylene-ethyl (meth)acrylate copolymer, ethylene-isopropyl (meth)acrylate copolymer, ethylene-n-propyl (meth)acrylate, ethylene-isobutyl (meth)acrylate copolymer, and ethylene-n-butyl (meth)acrylate copolymer, and more preferably contains an ethylene-vinyl acetate copolymer.

In the present embodiment, the ethylene-unsaturated ester copolymer (A) may be used singly or two or more kinds thereof may be used in combination.

In the present invention, from the viewpoint of further suppressing the resin protrusion from the edge of the laminated glass or solar cell modules thus obtainable, the melt flow rate (MFR) of the ethylene-unsaturated ester copolymer (A) as measured according to JIS K7210:1999 under the conditions of 190°C and a load of 2,160 g is 10 g/10 minutes or less, preferably 9 g/10 minutes or less, more preferably 8 g/10 minutes or less, and particularly preferably 7 g/10 minutes or less. When the MFR is equal to or lower than the upper limit described above, the heat resistance, mechanical strength, optical characteristics, and the like of the laminated glass interlayer film or solar cell encapsulant thus obtainable can be further improved, resulting in improvement in the processing processability of the laminated glass.

In the present embodiment, from the viewpoint of further improving the processability of the resin composition, the melt flow rate (MFR) of the ethylene-unsaturated ester copolymer (A) as measured according to JIS K7210:1999 under the conditions of 190°C and a load of 2, 160 g, is preferably 0.1 g/10 minutes or more, more preferably 1 g/10 minutes or more, and particularly preferably 2 g/10 minutes or more.

The MFR of the ethylene-unsaturated ester copolymer (A) may be adjusted by blending a plurality of ethylene-unsaturated ester copolymers (A) having different MFRs. Here, when a plurality of ethylene-unsaturated ester copolymers (A) having different MFRs are blended, the MFR of the blended product is regarded as the MFR of the ethylene-unsaturated ester copolymer (A).

With regard to the ethylene-unsaturated ester copolymer (A) according to the present embodiment, when the total amount of the ethylene-unsaturated ester copolymer is designated as 100% by mass, the content of constituent units derived from ethylene is preferably 52% by mass or more and 72% by mass or less, and more preferably 54% by mass or more and 70% by mass or less.

When the content of the constituent units derived from ethylene is equal to or larger than the lower limit described above, the heat resistance, mechanical strength, water resistance, processability, and the like of the laminated glass interlayer film or solar cell encapsulant thus obtainable can be further improved. Furthermore, when the content of the constituent units derived from ethylene is equal to or smaller than the upper limit described above, the transparency, flexibility, adhesiveness, and the like of the laminated glass interlayer film or solar cell encapsulant thus obtainable can be further improved.

With regard to the ethylene-unsaturated ester copolymer (A) according to the present embodiment, when the total amount of the ethylene-unsaturated ester copolymer is designated as 100% by mass, the content of constituent units derived from an unsaturated ester is 30% by mass or more and 48% by mass or less, and more preferably 30% by mass or more and 46% by mass or less.

When the content of the constituent units derived from an unsaturated ester is equal to or larger than the lower limit described above, the transparency, flexibility, adhesiveness, and the like of the laminated glass interlayer film or solar cell encapsulant thus obtainable can be further improved. Furthermore, when the content of the constituent units derived from an unsaturated ester is equal to or smaller than the upper limit described above, the heat resistance, mechanical strength, water resistance, processability, and the like of the laminated glass interlayer film or solar cell encapsulant thus obtainable can be further improved.

The method for producing the ethylene-unsaturated ester copolymer (A) according to the present embodiment is not particularly limited, and the copolymer may be produced by a known method. For example, various polymerization components can be obtained by performing radical copolymerization at high temperature and high pressure. A commercially available product may be used as the ethylene-unsaturated ester copolymer (A).

In the resin composition (P) according to the present embodiment, when the total amount of the resin composition is designated as 100% by mass, the total content of the ethylene-unsaturated ester copolymer (A) and the crosslinking agent (B) is preferably 60% by mass or more, more preferably 70% by mass or more, still more preferably 80% by mass or more, and particularly preferably 90% by mass or more. When the total content of the ethylene-unsaturated ester copolymer (A) and the crosslinking agent (B) is within the above range, it is possible to further improve the balance between the optical characteristics, adhesiveness, water resistance, mechanical characteristics, heat resistance, handleability, processability, and the like of the laminated glass interlayer film or solar cell encapsulant thus obtainable.

### <Crosslinking agent (B)>

The resin composition (P) according to the present embodiment contains a crosslinking agent (B) as an essential component.

When the resin composition (P) according to the present embodiment contains the crosslinking agent (B), heat resistance can be imparted to the laminated glass interlayer film or solar cell encapsulant thus obtainable.

As the crosslinking agent (B), an organic peroxide is preferred, and a 1-hour half-life temperature (decomposition temperature) thereof is preferably 90 to 180°C, and more preferably 100 to 150°C.

Examples of such organic peroxides include t-butylperoxyisopropyl carbonate, t-butylperoxy-2-ethylhexyl carbonate, t-butylperoxyacetate, t-butylperoxybenzoate, dicumyl peroxide, 2,5-dimethyl-2,5-bis(t-butylperoxy)hexane, di-t-butylperoxide, 2,5-dimethyl-2,5-bis(t-butylperoxy)hexyne-3, 1,1-bis(t-butylperoxy)-3,3,5-trimethylcyclohexane, 1,1-bis (t-butylperoxy) cyclohexane, methyl ethyl ketone peroxide, 2,5-dimethylhexyl-2,5-bisperoxybenzoate, t-butyl hydroperoxide, p-menthane hydroperoxide, benzoyl peroxide, p-chlorobenzoyl peroxide, t-butyl peroxy isobutyrate, hydroxyheptyl peroxide, and cyclohexanone peroxide.

Among these, a compound having at least a branched alkylperoxy group having 3 to 6 carbon atoms is preferred, a compound having at least a t-butylperoxy group is more preferred, and 2,5-dimethyl-2,5-bis(t-butylperoxy)hexane [1-hour half-life temperature = 140°C] and t-butylperoxy-2-ethylhexyl carbonate [1-hour half-life temperature = 121°C] are more preferred, and t-butylperoxy-2-ethylhexyl carbonate (TBEC) is particularly preferred from the viewpoint of the crosslinking rate and the process for producing the laminated glass.

The crosslinking agent (B) may be contained in an amount of preferably 0.1 to 1.5 parts by mass, more preferably 0.2 to 1.0 parts by mass, still more preferably 0.3 to 1.0 parts by mass, and particularly preferably 0.4 to 1.0 parts by mass based on 100 parts by mass of the ethylene-unsaturated ester copolymer (A).

When t-butylperoxy-2-ethylhexyl carbonate (TBEC) is contained as the crosslinking agent (B), t-butylperoxy-2-ethylhexyl carbonate (TBEC) may be contained in an amount of preferably 0.2 to 1.5 parts by mass, more preferably 0.3 to 1.0 parts by mass, still more preferably 0.4 to 1.0 parts by mass, and particularly preferably 0.4 to 0.8 parts by mass based on 100 parts by mass of the ethylene-unsaturated ester copolymer (A).

### <Other components>

In the resin composition (P) according to the present embodiment, components other than the ethylene-unsaturated ester copolymer (A) and the crosslinking agent (B) may be incorporated to the extent that does not impair the object of the present invention. Other components are not particularly limited, and examples thereof include a crosslinking aid, a silane coupling agent, an ultraviolet absorber, a light stabilizer, and an antioxidant. The other components may be used singly, or two or more kinds thereof may be used in combination.

Examples of the crosslinking aid include polyunsaturated compounds such as polyallyl compounds and poly (meth)acryloxy compounds. More specific examples thereof include polyallyl compounds such as triallyl isocyanurate, triallyl cyanurate, diallyl phthalate, diallyl fumarate, and diallyl maleate; poly (meth) acryloxy compounds such as ethylene glycol diacrylate, ethylene glycol dimethacrylate, and trimethylolpropane trimethacrylate; and divinylbenzene.

The crosslinking aid may be contained in an amount of, for example, 5 parts by mass or less, preferably 0.1 to 3 parts by mass, and more preferably 0.1 to 1 part by mass based on 100 parts by mass of the ethylene-unsaturated ester copolymer (A).

Examples of the silane coupling agent include a silane coupling agent having a vinyl group, an amino group or an alkoxy group, and a hydrolyzable group such as an epoxy group. More specific examples thereof include vinyltrimethoxysilane, vinyltriethoxysilane, γ-methacryloxypropyltrimethoxysilane, γ-methacryloxypropylmethyldimethoxysilane, γ-acryloxypropyltrimethoxysilane, γ-glycidoxypropyltrimethoxysilane, 3-glycidoxypropylmethyldimethoxysilane, 3-glycidoxypropylmethyldiethoxysilane, N-2-(aminoethyl)-3-aminopropyltrimethoxysilane, N-2-(aminoethyl)-3-aminopropylmethyldiethoxysilane, 3-aminopropyltrimethoxysilane, 3-aminopropyltriethoxysilane, N-phenyl-3-aminopropyltrimethoxysilane, and N-phenyl-3-aminopropyltriethoxysilane.

The silane coupling agent may be contained in an amount of, for example, 5 parts by mass or less, preferably 0.02 to 3 parts by mass, and more preferably 0.05 to 1 part by mass based on 100 parts by mass of the ethylene-unsaturated ester copolymer (A). When the silane coupling agent is contained in the above range, the adhesiveness of the resin composition (P) can be further improved.

Further, in order to prevent the deterioration of the resin composition (P) due to ultraviolet rays, the resin composition (P) according to the present embodiment preferably contains an ultraviolet absorber, a light stabilizer, an antioxidant and the like.

Examples of the ultraviolet absorber used include benzophenone-based ultraviolet absorbers such as 2-hydroxy-4-methoxybenzophenone, 2,2'-dihydroxy-4-methoxybenzophenone, 2-hydroxy-4-methoxy-2-carboxybenzophenone, and 2-hydroxy-4-n-octoxybenzophenone; benzotriazole-based ultraviolet absorbers such as 2-(2H-benzotriazol-2-yl)-4,6-di-tert-pentylphenol, 2-(2'-hydroxy-3',5'-di-t-butylphenyl)benzotriazole, 2-(2'-hydroxy-5-methylphenyl)benzotriazole, and 2-(2'-hydroxy-5-t-octylphenyl)benzotriazole; and salicylic acid ester-based ultraviolet absorbers such as phenyl salicylate and p-octyl phenyl salicylate.

As the light stabilizer, a hindered amine-based light stabilizer or the like may be used.

As the antioxidant, various hindered phenol-based antioxidants, phosphite-based antioxidants, or the like may be used.

The antioxidant, light stabilizer, and ultraviolet absorber may each be contained in an amount of, for example, 5 parts by mass or less, preferably 0.001 to 3 parts by mass, and more preferably 0.01 to 1 part by mass based on 100 parts by mass of the ethylene-unsaturated ester copolymer (A).

Further, the resin composition (P) according to the present embodiment may contain additives such as a colorant, a light diffusing agent, and a flame retardant, if necessary, in addition to the above-mentioned additives.

Examples of the colorant include pigments, inorganic compounds, and dyes, and examples of the white colorant include titanium oxide, aluminum oxide, zinc oxide, calcium oxide, calcium carbonate, barium carbonate, and barium sulfate. When the resin composition (P) containing these additives is used as an encapsulant on the light receiving side of a solar cell element, transparency may be impaired, but it can be preferably used as an encapsulant on the opposite side to the light receiving side of a solar cell element.

Examples of the light diffusing agent include inorganic spherical substances such as glass beads, silica beads, silicon alkoxide beads, and hollow glass beads. Examples of the organic spherical substances include acrylic and vinylbenzene plastic beads.

Examples of the flame retardant include halogen-based flame retardants such as bromides, phosphorus-based flame retardants, silicone-based flame retardants, and metal hydrates such as magnesium hydroxide and aluminum hydroxide.

### <Haze>

With regard to the resin composition (P) according to the present embodiment, the haze as measured by the following method is preferably less than 2.5%, more preferably less than 2.0%, more preferably less than 1.0%, and still more preferably less than 0.6%, and particularly preferably less than 0.5%. When the haze is equal to or less than the upper limit described above, the transparency of the laminated glass or solar cell module thus obtainable can be further improved.

In order to achieve such haze, the crosslinking rate represented by (T₅₀-T₁₀) / (Y-X) and the types and contents of the ethylene-unsaturated ester copolymer (A) and the crosslinking agent (B) in the resin composition (P) according to the present embodiment may be adjusted as appropriate.

The lower limit of the haze of the resin composition (P) according to the present embodiment is not particularly limited; however, for example, the lower limit is 0.01% or higher.

When the resin composition (P) according to the present embodiment is used, the haze of the laminated glass according to the present embodiment may be adjusted to a value of less than 2.5%. A preferred haze of the laminated glass is the same as described above.

### (Method)

A film having a size of 120 mm × 75 mm formed from the resin composition (P) according to the present embodiment is obtained. Next, the film thus obtained is interposed between glass plates each having a size of 120 mm × 75 mm × 3.2 mm, and is subjected to thermal crimping for 60 minutes at 130°C and 1 atm in a vacuum laminator to obtain a laminated glass. Next, the haze of the laminated glass thus obtained is measured according to JIS K7136: 2000 using a haze meter.

### <Protrusion length>

In the present embodiment, the protrusion length of the resin composition (P) as measured by the following method is preferably less than 10 mm, more preferably 9 mm or less, still more preferably 5 mm or less, and particularly preferably 1 mm or less. When the protrusion length is equal to or less than the upper limit described above, the appearance of a laminated glass or a solar cell module thus obtainable can be further improved.

Although the crosslinking rate represented by (T₅₀-T₁₀) / (Y-X) and the types and contents of the ethylene-unsaturated ester copolymer (A) and the crosslinking agent (B) in the resin composition (P) according to the present embodiment may be adjusted as appropriate in order to achieve such a length of the cloudy portion, particularly important factors therefor are the crosslinking rate represented by (T₅₀-T₁₀) / (Y-X) and the MFR of the ethylene-unsaturated ester copolymer (A).

The lower limit of the protrusion length of the resin composition (P) according to the present embodiment is preferably 0.0 mm.

### (Method)

A film having a size of 120 mm × 75 mm formed from the resin composition (P) according to the present embodiment is obtained. Next, the film thus obtained is interposed between glass plates each having a size of 120 mm × 75 mm × 3.2 mm, and is subjected to thermal crimping for 60 minutes at 130°C and 1 atm in a vacuum laminator to obtain a laminated glass. Next, a protrusion length of the resin composition thus obtained protruding from an edge of the laminated glass in a direction perpendicular to a cross-section of the laminated glass is measured. The protrusion length is a length measured perpendicularly from the center point of the long side of the glass, and is an average value of two points measured on each long side.

Examples of the shape of the resin composition (P) according to the present embodiment include a sheet shape and a film shape.

### 2. Laminated glass interlayer film and solar cell encapsulant

The laminated glass interlayer film 11 according to the present embodiment is formed from the resin composition (P) according to the present embodiment.

The thickness of the laminated glass interlayer film 11 according to the present embodiment is, for example, 0.1 mm or more and 10 mm or less, preferably 0.2 mm or more and 5 mm or less, and more preferably 0.3 mm or more and 2 mm or less.

When the thickness of the glass interlayer film 11 is or equal to or larger than the lower limit, the mechanical strength of the glass interlayer film 11 can be further improved. Furthermore, when the thickness of the glass interlayer film 11 is equal to or less than the upper limit, the optical characteristics and interlayer adhesiveness of the laminated glass thus obtainable can be further improved.

The method for producing the laminated glass interlayer film 11 according to the present embodiment is not particularly limited, and any conventionally known production method may be used.

Regarding the method for producing the laminated glass interlayer film 11 according to the present embodiment, for example, a press molding method, an extrusion molding method, a T-die molding method, an injection molding method, a compression molding method, a cast molding method, a calendar molding method, or an inflation molding method may be used.

A solar cell encapsulant according to the present embodiment is formed from the resin composition (P) according to the present embodiment.

The solar cell encapsulant according to the present embodiment preferably has the same film thickness as the laminated glass interlayer film, and the solar cell encapsulant may also be produced by a similar production method.

### 3. Laminated glass

Fig. 2 is a cross-sectional view schematically illustrating an example of the structure of a laminated glass 10 according to the embodiments of the present invention.

The laminated glass 10 according to the present embodiment includes the laminated glass interlayer film 11 according to the present embodiment, and transparent plate-like members 13 provided on both surfaces of the laminated glass interlayer film 11. The laminated glass 10 according to the present embodiment includes the laminated glass interlayer film 11 according to the present embodiment and therefore has an excellent performance balance between optical characteristics and moisture-resistant adhesiveness between the glass interlayer film 11 and the transparent plate-like member 13.

Two or more layers of the laminated glass interlayer film 11 may be used, or the laminated glass interlayer film 11 may be composed of three or more layers by interposing a layer formed from another resin between two sheets of the laminated glass interlayer film 11.

The transparent plate-like member 13 is not particularly limited; however, for example, a generally used transparent plate glass may be used, and examples thereof include inorganic glass such as float plate glass, polished plate glass, figured glass, network wired plate glass, wired plate glass, colored plate glass, heat-ray absorbing plate glass, heat-ray reflective plate glass, and green glass. Furthermore, organic plastic plates such as a polycarbonate plate, a poly (meth) acrylate plate, a polymethyl (meth) acrylate plate, a polystyrene plate, a cyclic polyolefin plate, a polyethylene terephthalate plate, a polyethylene naphthalate plate, and a polyethylene butyrate plate may also be used.

The transparent plate-like member 13 may be appropriately subjected to a surface treatment such as a corona treatment, a plasma treatment, or a flame treatment.

The thickness of the transparent plate-like member 13 is, for example, 1 mm or more and 20 mm or less. In the laminated glass 10 according to the present embodiment, regarding the respective transparent plate-like members 13 provided on both surfaces of the laminated glass interlayer film 11, the same members may be used, or different plate-like members may be used in combination.

The method for producing the laminated glass 10 according to the present embodiment is not particularly limited, and for example, conventionally known production methods such as a nip roll method, an autoclave method, a vacuum bag method, and a vacuum laminator method may be used. Production may be carried out using one kind of these techniques, or production can also be carried out using two or more kinds of production methods in combination.

As the method for producing the laminated glass 10 according to the present embodiment, for example, as shown in Fig. 2, a method of interposing the laminated glass interlayer film 11 according to the present embodiment between two sheets of the transparent plate-like member 13 and then heating and pressurizing the assembly, or the like may be used.

Among these, as a method for producing the laminated glass 10 according to the present embodiment, a method in which a nip roll method and an autoclave method are combined, or a method in which a vacuum bag method and an autoclave method are combined is preferred.

The method in which a nip roll method and an autoclave method are combined is, for example, a method in which a laminate obtained by interposing the laminated glass interlayer film 11 according to the present embodiment between two transparent plate-like members 13 is temporarily crimped by a nip roll, and then the laminate is thermally crimped by heating and pressurizing treatment using an autoclave to obtain the laminated glass 10.

The method in which a vacuum bag method and an autoclave method are combined is, for example, a method in which a laminate obtained by interposing the laminated glass interlayer film 11 according to the present embodiment between two transparent plate-like members 13 is put into a vacuum bag, and then the laminate is temporarily crimped by reducing the pressure in the vacuum bag, and then the laminate is thermally crimped by heating and pressurizing treatment using an autoclave to obtain the laminated glass 10.

These laminated glasses may be used in various use applications, and for example, the laminated glasses may be used for laminated glasses for construction, laminated glasses for automobiles, general constructions, agricultural constructions, and windows for railways; however, the use is not limited to these use applications.

### 4. Solar cell module

A solar cell module according to the present embodiment includes at least a substrate to which solar light is incident; a solar cell element; and the solar cell encapsulant according to the present embodiment. The solar cell module according to the present embodiment may further include a protective material as necessary. Meanwhile, the substrate to which solar light is incident may be simply referred to as substrate.

The solar cell module according to the present embodiment may be produced by fixing a solar cell element encapsulated by the solar cell encapsulant according to the present embodiment onto the substrate.

Regarding such a solar cell module, various types of solar cell modules may be mentioned as examples. Examples include a solar cell module having a configuration in which a solar cell element is interposed between encapsulants on both sides of the solar cell element, as in the case of substrate/encapsulant/solar cell element/encapsulant/protective material; a solar cell module in which a solar cell element formed in advance on the surface of a substrate such as glass, is configured as in the case of substrate/solar cell element/encapsulant/protective material; and a solar cell module having a configuration in which an encapsulant and a protective material are formed on a solar cell element formed on the inner peripheral surface of the substrate, for example, an amorphous solar cell element produced on a fluororesin-based sheet by sputtering or the like.

Meanwhile, when the substrate to which solar light is incident is designated as the upper part of the solar cell module, since the protective material is provided on the opposite side of the substrate side of the solar cell module, that is, in the lower part, the protective material may also be referred to as lower protective material.

Regarding the solar cell element, various solar cell elements including silicon systems such as monocrystalline silicon, polycrystalline silicon, and amorphous silicon; and Group III-V or Group II-VI compound semiconductor systems such as gallium-arsenic, copper-indium-selenium, copper-indium-gallium-selenium, and cadmium-tellurium, maybe used. The solar cell encapsulant according to the present embodiment is particularly useful for the encapsulation of an amorphous silicon solar cell element and a heterojunction type solar cell element of amorphous silicon and monocrystalline silicon.

Examples of the substrate that constitutes the solar cell module according to the present embodiment include a glass substrate, an acrylic resin substrate, a polycarbonate substrate, a polyester substrate, and a fluorine-containing resin substrate.

As the protective material (lower protective material), a single substance or a multilayer sheet formed of a metal, a variety of thermoplastic resins, or the like may be used, and examples thereof include single-layer or multilayer sheets formed of metals such as tin, aluminum, and stainless steel; inorganic materials such as glass; a polyester, an inorganic vapor deposited polyester, a fluorine-containing resin, a polyolefin, and the like. The solar cell encapsulant according to the present embodiment exhibits satisfactory adhesiveness to these substrates or protective materials.

The method for producing the solar cell module according to the present embodiment is not particularly limited, and for example, conventionally known production methods such as a nip roll method, an autoclave method, a vacuum bag method, and a vacuum laminator method may be used. Production may be carried out using one kind of these techniques, or production can also be carried out using two or more kinds of production methods in combination.

Among them, as the method for producing the solar cell module according to the present embodiment, a production method using a vacuum laminator is preferred.

The method using a vacuum laminator is, for example, a method in which a laminate obtained by interposing the solar cell encapsulant and the solar cell element according to the present embodiment between a substrate and a protective material is heated and vacuum-degassed in a double vacuum apparatus, and then, in a pressurizing step, a diaphragm rubber is subjected to thermal crimping from the upper part of the double vacuum to the laminate by heating and pressurizing treatment to obtain a solar cell module.

The embodiments of the present invention have been described above with reference to the drawings; however, these are only examples of the present invention, and various configurations in addition to the above-described configurations can also be employed.

### [EXAMPLES]

Hereinafter, the present invention will be specifically described based on Examples; however, the present invention is not intended to be limited to these Examples.

### (1) Evaluation methods

### [Crosslinking rate]

The apparatus used was a moving die rheometer (MDR) MDR-2000P manufactured by Alpha Technology Co., Ltd.

The laminated glass interlayer films having a thickness of 450 µm obtained in Examples and Comparative Examples were cut into about 30 mm square and used as a measurement sample.

The apparatus was set at the measurement condition of 130°C, and after confirming that the temperature of the apparatus was stabilized, the sample was set in the apparatus, and the measurement of the melting torque of the sample was started (frequency 1.66 Hz) . Generally, the torque decreases once the measurement is started (the minimum viscosity is defined as Tₘᵢₙ). Thereafter, the degree of increase in torque changes depending on the progress of crosslinking.

When the torque value 60 minutes after the start of measurement is defined as T₁₀₀ [dN·m], the torque value of 10% of T₁₀₀ is defined as T₁₀, the torque value of 50% of T₁₀₀ is defined as T₅₀, the minimum torque value during measurement is defined as Tₘᵢₙ, the time to reach T₁₀ from the start of measurement is defined as X [min], and the time to reach T₅₀ from the start of measurement is defined as Y [min], the value represented by (T₅₀-T₁₀)/(Y-X) (where T₅₀ = (T₁₀₀-Tₘᵢₙ) × 0.5 + Tₘᵢₙ, T₁₀ = (T₁₀₀-Tₘᵢₙ) × 0.1 + Tₘᵢᵣ) was evaluated as the crosslinking rate of the resin composition.

### [Optical characteristics]

The laminated glass interlayer films obtained in Examples and Comparative Examples were cut into a size of 120 mm × 75 mm. Next, the test piece thus obtained was interposed between glass plates each having a size of 120 mm × 75 mm × 3.2 mm (manufactured by Asahi Glass Co., Ltd., product name: float plate glass, total light transmittance: 90.4%, haze: 0.2%), and was subjected to thermal crimping for 60 minutes at 130°C and 1 atm in a vacuum laminator to obtain a laminated glass. The laminated glass thus obtained was cooled by slowly cooling so as to return to room temperature over about 30 minutes. Next, the haze and the total light transmittance of the laminated glass thus obtained were measured according to JIS K7136: 2000 using a haze meter (manufactured by Murakami Color Research Laboratory Co., Ltd., product name: HAZE METER HM150).

### [Moisture-resistant adhesiveness]

The laminated glass interlayer films obtained in Examples and Comparative Examples were cut into a size of 120 mm × 75 mm. Next, the test piece thus obtained was laminated on a glass plate having a size of 120 mm × 75 mm × 3.2 mm (manufactured by Asahi Glass Co., Ltd., white float plate glass), and thermal crimping was performed for 60 minutes at 130°C and 1 atm in a vacuum laminator, whereby the test piece was bonded to the glass plate to obtain a laminate. Then, the laminate was stored in an environment of 85°C and 90%RH for 500 hours and 1000 hours. Next, the test piece was separated from the glass plate at a tensile rate of 100 mm/min, and the maximum stress was calculated as the adhesive strength (N) to a glass plate. The adhesive strength was measured for each of the adhesive strength of the laminate after storage in an environment of 85°C and 90% RH for 500 hours and 1000 hours, and the adhesive strength of the laminate before storage.

### [Protrusion length of resin composition (P)]

The laminated glass interlayer films obtained in Examples and Comparative Examples were cut into a size of 120 mm × 75 mm. Next, the test piece thus obtained was interposed between glass plates each having a size of 120 mm × 75 mm × 3.2 mm (manufactured by Asahi Glass Co., Ltd., product name: float plate glass), and was subjected to thermal crimping for 60 minutes at 130°C and 1 atm in a vacuum laminator to obtain a laminated glass. The laminated glass thus obtained was cooled by slowly cooling so as to return to room temperature over about 30 minutes. Then, the length of the resin composition perpendicularly protruding from the center point of the long side of the glass was measured using a caliper. The average value of the measurement at the center point of each long side was defined as the protrusion length.

### (2) Materials

Details of the materials used for the production of laminated glasses are as follows.

### <Ethylene-unsaturated ester copolymer (A)>

EVA1: ethylene-vinyl acetate copolymer (MFR = 14 g/10 min, ethylene content = 67% by mass, vinyl acetate content = 33% by mass)
EVA2: ethylene-vinyl acetate copolymer (MFR = 1.0 g/10 min, ethylene content = 67% by mass, vinyl acetate content = 33% by mass)
EVA3: ethylene-vinyl acetate copolymer (MFR = 30 g/10 min, ethylene content = 65% by mass, vinyl acetate content = 35% by mass)
EVA4: ethylene-vinyl acetate copolymer (MFR = 4.3 g/10 min, ethylene content = 74% by mass, vinyl acetate content = 26% by mass)

### <Crosslinking agent (B)>

Crosslinking agent 1:
   2,5-dimethyl-2,5-bis(t-butylperoxy)hexane (1-hour half-life temperature: 140°C)
Crosslinking agent 2: t-butylperoxy-2-ethylhexyl carbonate (1-hour half-life temperature: 121°C)

### <Other components>

Crosslinking aid 1: triallyl isocyanurate
Ultraviolet absorber 1: benzophenone-based ultraviolet absorber
Light stabilizer 1: Hindered amine-based light stabilizer
Antioxidant 1: Hindered phenol-based antioxidant
Silane coupling agent 1: γ-methacryloxypropyltrimethoxysilane

### (3) Examples 1 to 3 (not belonging to the invention) Examples 4 to 8 (according to the invention) and Comparative Examples 1 to 4

The components were pre-blended at the blending ratios shown in Tables 1 and 2, and the resin composition thus obtained was extruded using a 40 mmφ profile extruder (L/D = 26) with cylinder temperatures set at C1 (tip) : 70°C, C2 (middle) : 80°C, and C3 (rear) : 90°C to give a laminated glass interlayer film having a thickness of 450 µm.

The above-described evaluations were respectively carried out for the laminated glass interlayer films thus obtained. The results thus obtained are respectively presented in Tables 1 and 2.

**[Table 1]**

| | | Example 1 | Example 2 | Example 3 | Comparative Example 1 | Comparative Example 2 | Comparative Example 3 | Comparative Example 4 |
|---|---|---|---|---|---|---|---|---|
| Ethylene-unsaturated ester copolymer (A) | EVA1 [parts by mass] | 100 | 100 | 100 | 100 | 100 | - | - |
| | EVA3 [parts by mass] | - | - | - | - | - | 100 | |
| | EVA4 [parts by mass] | - | - | - | - | - | - | 100 |
| Crosslinking agent (B) | Crosslinking agent 1 [parts by mass] | 0.1 | 0.1 | - | 0.1 | 0.2 | 1.2 | 1.2 |
| | Crosslinking agent 2 [parts by mass] | 0.4 | 0.4 | 0.4 | 0.1 | - | - | - |
| Crosslinking aid | Crosslinking aid 1 | - | 0.4 | 0.4 | 0.4 | 0.4 | 0.03 | 0.5 |
| Ultraviolet absorber | Ultraviolet absorber 1 | 0.3 | 0.3 | 0.3 | 0.3 | 0.3 | 0.3 | 0.2 |
| Light stabilizer | Light stabilizer 1 | 0.1 | 0.1 | 0.1 | 0.1 | 0.1 | 0.1 | 0.1 |
| Antioxidant \| | Antioxidant 1 | 0.02 | 0.02 | 0.02 | 0.02 | 0.02 | 0.07 | 0.03 |
| Silane coupling agent | Silane coupling agent 1 | 0.2 | 0.2 | 0.2 | 0.2 | 0.2 | 0.12 | 0.14 |

| Evaluation results | | | | | | | | |
|---|---|---|---|---|---|---|---|---|
| MFR of copolymer (A) | [g/10min.] (190 °C/2160 g load) | 14 | 14 | 14 | 14 | 14 | 30 | 4.3 |
| Crosslinking rate | T₁₀₀ [dN·m] | 3.4 | 4.19 | 4.33 | 0.91 | 0.27 | 4.41 | 10.82 |
| | (T₅₀-T₁₀)/(Y-X) [dN·m/min] | 0.10 | 0.13 | 0.14 | 0.01 | 0.00 | 0.26 | 0.88 |
| Optical characteristics | Total light transmittance [%] | 88.4 | 88.4 | 88.2 | 88.5 | 88.4 | 88.7 | 88.7 |
| | Haze [%] | 2.2 | 1.8 | 1.5 | 2.6 | 2.8 | 0.3 | 0.4 |
| Moisture-resistant adhesiveness | Initial adhesive strength [N] | 30.2 | 32.2 | 29.9 | 15.4 | 10.5 | 18.6 | 18.3 |
| | Adhesive strength after 500 hours | 29.1 | 30.1 | 28.2 | 13.8 | 8.8 | 12.3 | 19.5 |
| | Adhesive strength after 1000 hours | 29.6 | 31.1 | 28.7 | 11 | 5.4 | 11.0 | 17.9 |
| Protrusion length [mm] of resin composition (P) | | 8 | 5 | 5 | >10 | >10 | >10 | 1 |

**[Table 2]**

| | | Example 4 | Example 5 | Example 6 | Example 7 | Example 8 |
|---|---|---|---|---|---|---|
| Ethylene-unsaturated ester copolymer (A) | EVA1 [parts by mass] | 25 | 25 | 50 | 25 | |
| | EVA2 [parts by mass] | 75 | 75 | 50 | 75 | 100 |
| Crosslinking agent (B) | Crosslinking agent 1 [parts by mass] | - | - | - | - | - |
| | Crosslinking agent 2 [parts by mass] | 0.8 | 0.8 | 0.4 | 0.4 | 0.4 |
| Crosslinking aid | Crosslinking aid 1 | 0.4 | 0.8 | 0.4 | 0.4 | 0.4 |
| Ultraviolet absorber | Ultraviolet absorber 1 | 0.3 | 0.3 | 0.3 | 0.3 | 0.3 |
| Light stabilizer | Light stabilizer 1 | 0.1 | 0.1 | 0.1 | 0.1 | 0.1 |
| Antioxidant | Antioxidant 1 | 0.02 | 0.02 | 0.02 | 0.02 | 0.02 |
| Silane coupling agent | Silane coupling agent | 0.2 | 0.2 | 0.2 | 0.2 | 0.2 |

| Evaluation results | | | | | | |
|---|---|---|---|---|---|---|
| MFR of copolymer (A) | [g/10min.] (190°C/2160 g load) | 1.9 | 1.9 | 4.0 | 1.9 | 1.0 |
| Crosslinking rate | T₁₀₀ [dN·m] | 4.26 | 4.88 | 2.22 | 2.78 | 1.97 |
| | (T₅₀-T₁₀)/(Y-X) [dN·m/min] | 0.11 | 0.14 | 0.04 | 0.05 | 0.03 |
| Optical characteristics | Total light transmittance [%] | 91.3 | 91.2 | 91.3 | 91.3 | 91.3 |
| | Haze [%] | 0.2 | 0.2 | 0.2 | 0.2 | 0.2 |
| Moisture-resistant adhesiveness | Initial adhesive strength [N] | 32.5 | 35 | 32.2 | 32.5 | 29.6 |
| | Adhesive strength after 500 hours | 31.1 | 32.2 | 29.4 | 29.2 | 29.9 |
| | Adhesive strength after 1000 hours | 30.1 | 31.9 | 26.0 | 26.6 | 27.8 |
| Protrusion length [mm] of resin composition (P) | | 0 | 0 | 1 | 1 | 0 |

The laminated glass interlayer films of Examples were excellent in performance balance between optical characteristics and moisture-resistant adhesiveness. Further, the laminated glass thus obtained had a short resin protrusion length and had an excellent appearance. In contrast, the laminated glass interlayer films of Comparative Examples were poor in performance balance between optical characteristics and moisture-resistant adhesiveness.

## Claims

1. A resin composition for a laminated glass interlayer film or a solar cell encapsulant,
the resin composition comprising an ethylene-unsaturated ester copolymer (A) and a crosslinking agent (B),
wherein,
when a total amount of the ethylene-unsaturated ester copolymer (A) is designated as 100% by mass, a content of constituent units derived from an unsaturated ester in the ethylene-unsaturated ester copolymer (A) is 30% by mass or more and 48% by mass or less, and
when a torque of the resin composition is measured over time at 130°C using a moving die rheometer, a torque value 60 minutes after the start of measurement is defined as T₁₀₀ [dN·m], a torque value of 10% of T₁₀₀ is defined as T₁₀, a torque value of 50% of T₁₀₀ is defined as T₅₀, a minimum torque value during measurement is defined as Tₘᵢₙ, a time to reach T₁₀ from the start of measurement is defined as X [min], and a time to reach T₅₀ from the start of measurement is defined as Y [min],
a crosslinking rate represented by (T₅₀-T₁₀)/ (Y-X) (where T₅₀ = (T₁₀₀-Tₘᵢₙ) × 0.5 + Tₘᵢₙ, T₁₀ = (T₁₀₀-Tₘᵢₙ) × 0.1 + Tₘᵢₙ) is more than 0.01 dN·m/min and 0.25 dN·m/min or less, and
wherein the ethylene-unsaturated ester copolymer (A) has a melt flow rate (MFR) of 10 g/10 minutes or less as measured according to JIS K7210: 1999 under the conditions of 190°C and 2,160 g load.

2. The resin composition according to claim 1,
wherein the ethylene-unsaturated ester copolymer (A) contains at least one polymer selected from an ethylene-vinyl ester copolymer and an ethylene-unsaturated carboxylic acid ester copolymer.

3. The resin composition according to claim 2,
wherein the ethylene-unsaturated ester copolymer (A) contains an ethylene-vinyl acetate copolymer.

4. The resin composition according to any one of claims 1 to 3,
wherein when a total amount of the ethylene-unsaturated ester copolymer (A) is designated as 100% by mass, a content of constituent units derived from an unsaturated ester in the ethylene-unsaturated ester copolymer (A) is 30% by mass or more and 46% by mass or less.

5. The resin composition according to any one of claims 1 to 4,
wherein the crosslinking agent (B) contains an organic peroxide.

6. The resin composition according to any one of claims 1 to 5,
wherein a haze as measured by the following method is less than 2.5%:
(Method)
A film having a size of 120 mm × 75 mm and formed from the cross-linked resin composition is obtained. Next, the film thus obtained is interposed between glass plates each having a size of 120 mm × 75 mm × 3.2 mm, and is subjected to thermal crimping for 60 minutes at 130°C and 1 atm in a vacuum laminator to obtain a laminated glass. Next, the haze of the laminated glass thus obtained is measured according to JIS K7136: 2000 using a haze meter.

7. The resin composition according to any one of claims 1 to 6,
wherein a protrusion length as measured by the following method is less than 10 mm:
(Method)
A film having a size of 120 mm × 75 mm and formed from the cross-linked resin composition is obtained. Next, the film thus obtained is interposed between glass plates each having a size of 120 mm × 75 mm × 3.2 mm, and is subjected to thermal crimping for 60 minutes at 130°C and 1 atm in a vacuum laminator to obtain a laminated glass. Next, a protrusion length of the resin composition thus obtained protruding from an edge of the laminated glass in a direction perpendicular to a cross-section of the laminated glass is measured.

8. The resin composition according to any one of claims 1 to 7,
wherein the resin composition is in the form of a sheet or a film.

9. A laminated glass interlayer film (11) formed from the resin composition according to any one of claims 1 to 8.

10. A laminated glass (10) comprising:
the laminated glass interlayer film (11) according to claim 9; and
a transparent plate-like member (13) provided on both surfaces of the laminated glass interlayer film (11).

11. A solar cell encapsulant formed from the resin composition according to any one of claims 1 to 8.

12. A solar cell module comprising the solar cell encapsulant according to claim 11.

## Patentansprüche

1. Harzzusammensetzung für einen Verbundglaszwischenschichtfilm oder ein Solarzelleneinkapselungsmittel,
wobei die Harzzusammensetzung ein Copolymer (A) aus Ethylen und einem ungesättigten Ester und einen Vernetzer (B) umfasst,
wobei,
wenn eine Gesamtmenge des Copolymers (A) aus Ethylen und einem ungesättigten Ester als 100 Masse-% festgelegt wird, ein Gehalt von Konstitutionseinheiten, die von einem ungesättigten Ester abgeleitet sind, in dem Copolymer (A) aus Ethylen und einem ungesättigten Ester 30 Masse-% oder mehr und 48 Masse-% oder weniger beträgt, und
wenn ein Drehmoment der Harzzusammensetzung über die Zeit bei 130 °C unter Verwendung eines Rheometers mit beweglicher Matrize gemessen wird, und ein Drehmomentwert 60 Minuten nach Beginn der Messung als T₁₀₀ [dN·m] definiert ist, ein Drehmomentwert von 10 % von T₁₀₀ als T₁₀ definiert ist, ein Drehmomentwert von 50 % von T₁₀₀ als T₅₀ definiert ist, ein Mindestdrehmomentwert während der Messung als Tₘᵢₙ definiert ist, eine Zeit bis zum Erreichen von T₁₀ ab dem Beginn der Messung als X [min] definiert ist, und eine Zeit bis zum Erreichen von T₅₀ ab dem Beginn der Messung als Y [min] definiert ist,
beträgt eine Vernetzungsrate, dargestellt durch (T₅₀-T₁₀)/(Y-X) (wobei T₅₀ = (T₁₀₀-Tₘᵢₙ) × 0,5 + Tₘᵢₙ, T₁₀ = (T₁₀₀-Tₘᵢₙ) × 0,1 + Tₘᵢₙ) mehr als 0,01 dN·m/min und weniger als oder gleich 0,25 dN·m/min, und
wobei das Copolymer (A) aus Ethylen und einem ungesättigten Ester einen Schmelzflussindex (MFR) von 10 g/10 Minuten oder weniger aufweist, gemessen gemäß JIS K7210: 1999 unter den Bedingungen von 190 °C und 2.160 g Last.

2. Harzzusammensetzung nach Anspruch 1,
wobei das Copolymer (A) aus Ethylen und einem ungesättigten Ester mindestens ein Polymer umfasst, ausgewählt aus einem Ethylen-Vinylester-Copolymer und einem Copolymer aus Ethylen und einem ungesättigten Carbonsäureester.

3. Harzzusammensetzung nach Anspruch 2,
wobei das Copolymer (A) aus Ethylen und einem ungesättigten Ester ein Ethylen-Vinylacetat-Copolymer enthält.

4. Harzzusammensetzung nach einem der Ansprüche 1 bis 3,
wobei, wenn eine Gesamtmenge des Copolymers (A) aus Ethylen und einem ungesättigten Ester als 100 Masse-% festgelegt wird, ein Gehalt von Grundeinheiten, die von einem ungesättigten Ester abgeleitet sind, in dem Copolymer (A) aus Ethylen und einem ungesättigten Ester 30 Masse-% oder mehr und 46 Masse-% oder weniger beträgt.

5. Harzzusammensetzung nach einem der Ansprüche 1 bis 4,
wobei der Vernetzer (B) ein organisches Peroxid enthält.

6. Harzzusammensetzung nach einem der Ansprüche 1 bis 5,
wobei eine nach dem folgenden Verfahren gemessene Trübung weniger als 2,5 % beträgt:
(Verfahren)
Ein Film, der eine Größe von 120 mm × 75 mm aufweist und aus der vernetzten Harzzusammensetzung ausgebildet ist, wird erhalten. Anschließend wird der so erhaltene Film zwischen Glasplatten mit einer Größe von jeweils 120 mm × 75 mm × 3, 2 mmangeordnet und 60 Minuten lang bei 130 °C und 1 atm in einem Vakuumlaminator thermisch gepresst, um ein Verbundglas zu erhalten. Anschließend wird die Trübung des so erhaltenen Verbundglases gemäß JIS K7136: 2000 unter Verwendung eines Trübungsmessgeräts gemessen.

7. Harzzusammensetzung nach einem der Ansprüche 1 bis 6,
wobei eine nach dem folgenden Verfahren gemessene Vorsprungslänge weniger als 10 mm beträgt:
(Verfahren)
Ein Film, der eine Größe von 120 mm × 75 mm aufweist und aus der vernetzten Harzzusammensetzung ausgebildet ist, wird erhalten. Anschließend wird der so erhaltene Film zwischen Glasplatten mit einer Größe von jeweils 120 mm × 75 mm × 3, 2 mmangeordnet und 60 Minuten lang bei 130 °C und 1 atm in einem Vakuumlaminator thermisch gepresst, um ein Verbundglas zu erhalten. Anschließend wird eine Vorsprungslänge der so erhaltenen Harzzusammensetzung gemessen, die von einem Rand des Verbundglases in einer Richtung senkrecht zu einem Querschnitt des Verbundglases hervorsteht.

8. Harzzusammensetzung nach einem der Ansprüche 1 bis 7,
wobei die Harzzusammensetzung in Form einer Folie oder eines Films ausgebildet ist.

9. Verbundglaszwischenschichtfilm (11), der aus der Harzzusammensetzung nach einem der Ansprüche 1 bis 8 ausgebildet ist.

10. Verbundglas (10), umfassend:
den Verbundglaszwischenschichtfilm (11) nach Anspruch 9; und
ein transparentes plattenartiges Element (13), das auf beiden Flächen des Verbundglaszwischenschichtfilms (11) vorgesehen ist.

11. Solarzelleneinkapselungsmittel, das aus der Harzzusammensetzung nach einem der Ansprüche 1 bis 8 ausgebildet ist.

12. Solarzellenmodul, umfassend das Solarzelleneinkapselungsmittel nach Anspruch 11.

## Revendications

1. Composition de résine pour un film intermédiaire de verre stratifié ou un encapsulant de cellule solaire,
la composition de résine comprenant un copolymère d' éthylène et d'ester insaturé (A) et un agent de réticulation (B),
dans laquelle,
lorsqu'une quantité totale du copolymère d' éthylène et d'ester insaturé (A) est désignée comme étant de 100 % en masse, une teneur en unités constitutives dérivées d'un ester insaturé dans le copolymère d' éthylène et d'ester insaturé (A) est de 30 % en masse ou plus et de 48 % en masse ou moins, et
lorsqu'un couple de la composition de résine est mesuré dans le temps à 130 °C à l'aide d'un rhéomètre à matrice mobile, une valeur de couple 60 minutes après le début de la mesure est définie comme T₁₀₀ [dN·m], une valeur de couple de 10 % de T₁₀₀ est définie comme T₁₀, une valeur de couple de 50 % de T₁₀₀ est définie comme T₅₀, une valeur de couple minimale pendant la mesure est définie comme Tₘᵢₙ, un temps pour atteindre T₁₀ à partir du début de la mesure est défini comme X [min], et un temps pour atteindre T₅₀ à partir du début de la mesure est défini comme Y [min],
un taux de réticulation représenté par (T₅₀-T₁₀)/(Y-X) (où T₅₀ = (T₁₀₀-Tₘᵢₙ) × 0,5 + Tₘᵢₙ, T₁₀ = (T₁₀₀-Tₘᵢₙ) × 0,1 + Tₘᵢₙ) est supérieure à 0,01 dN·m/min et inférieure ou égale à 0,25 dN·m/min, et
dans laquelle le copolymère d' éthylène et d'ester insaturé (A) a un débit à l'état fondu (MFR) de 10 g/10 minutes ou moins mesuré selon la norme JIS K7210: 1999 dans les conditions de 190 °C et 2.160 g de charge.

2. Composition de résine selon la revendication 1,
dans laquelle le copolymère d'éthylène et d'ester insaturé (A) contient au moins un polymère choisi parmi un copolymère d'éthylène et d'ester vinylique et un copolymère d'éthylène et d'ester d'acide carboxylique insaturé.

3. Composition de résine selon la revendication 2,
dans laquelle le copolymère d'éthylène et d'ester insaturé (A) contient un copolymère d'éthylène et d'acétate de vinyle.

4. Composition de résine selon l'une quelconque des revendications 1 à 3,
dans laquelle, lorsqu'une quantité totale du copolymère d' éthylène et d'ester insaturé (A) est désignée comme étant de 100 % en masse, une teneur en unités constitutives dérivées d'un ester insaturé dans le copolymère d' éthylène et d'ester insaturé (A) est de 30 % en masse ou plus et de 46 % en masse ou moins.

5. Composition de résine selon l'une quelconque des revendications 1 à 4,
dans laquelle l'agent de réticulation (B) contient un peroxyde organique.

6. Composition de résine selon l'une quelconque des revendications 1 à 5,
dans laquelle un trouble mesuré selon le procédé suivant est inférieur à 2,5 % :
(procédé)
Un film d'une taille de 120 mm × 75 mm formé à partir de la composition de résine réticulée est obtenu. Ensuite, le film ainsi obtenu est interposé entre des plaques de verre ayant chacune une dimension de 120 mm × 75 mm × 3,2 mm, et est soumis à un sertissage thermique pendant 60 minutes à 130 °C et 1 atm dans un laminateur sous vide pour obtenir un verre stratifié. Ensuite, le trouble du verre stratifié ainsi obtenu est mesuré selon la norme JIS K7136: 2000 à l'aide d'un mesureur de voile.

7. Composition de résine selon l'une quelconque des revendications 1 à 6,
dans laquelle une longueur de saillie mesurée selon le procédé suivant est inférieure à 10 mm :
(procédé)
Un film d'une taille de 120 mm × 75 mm formé à partir de la composition de résine réticulée est obtenu. Ensuite, le film ainsi obtenu est interposé entre des plaques de verre ayant chacune une dimension de 120 mm × 75 mm × 3,2 mm, et est soumis à un sertissage thermique pendant 60 minutes à 130 °C et 1 atm dans un laminateur sous vide pour obtenir un verre stratifié. Ensuite, une longueur de saillie de la composition de résine ainsi obtenue dépassant d'un bord du verre stratifié dans une direction perpendiculaire à une section transversale du verre stratifié est mesurée.

8. Composition de résine selon l'une quelconque des revendications 1 à 7,
dans laquelle la composition de résine se présente sous la forme d'une feuille ou d'un film.

9. Film intermédiaire de verre stratifié (11) formé à partir de la composition de résine selon l'une quelconque des revendications 1 à 8.

10. Verre stratifié (10) comprenant :
le film intermédiaire de verre stratifié (11) selon la revendication 9 ; et
un élément transparent en forme de plaque (13) prévu sur les deux surfaces du film intermédiaire de verre stratifié (11).

11. Encapsulant de cellule solaire formé à partir de la composition de résine selon l'une quelconque des revendications 1 à 8.

12. Module de cellule solaire comprenant l'encapsulant de cellule solaire selon la revendication 11.
